(19) Europäisches Patentamt
European Patent Office
Office européen des brevets

(11) Numéro de publication : **0 052 381**
**B1**

# (12) FASCICULE DE BREVET EUROPÉEN

(45) Date de publication du fascicule du brevet : **07.08.85**

(51) Int. Cl.[4] : **C 08 G 77/20**, C 08 L 83/04, C 08 G 77/28

(21) Numéro de dépôt : **81109998.5**

(22) Date de dépôt : **14.01.80**

(60) Numéro de publication de la demande initiale en application de l'article 76 CBE : **0016663**

(54) **Procédé de préparation de compositions organopolysiloxaniques photopolymérisables et utilisation de ces compositions.**

(30) Priorité : **24.01.79 FR 7901750**

(43) Date de publication de la demande : **26.05.82 Bulletin 82/21**

(45) Mention de la délivrance du brevet : **07.08.85 Bulletin 85/32**

(84) Etats contractants désignés : **DE NL SE**

(56) Documents cités :
**EP-A- 0 016 663**
**FR-A- 2 110 115**
**GB-A- 1 154 724**

(73) Titulaire : **RHONE-POULENC SPECIALITES CHIMIQUES**
**"Les Miroirs" 18, Avenue d'Alsace**
**F-92400 Courbevoie (FR)**

(72) Inventeur : **Pigeon, Raymond**
**52, Chemin Moulin du Got**
**F-69340-Francheville (FR)**

(74) Mandataire : **Chichery, Guy et al**
**RHONE-POULENC RECHERCHES Service Brevets Chimie et Polymères Centre de Recherches de Saint-Fons B.P. 62**
**F-69192 St-Fons Cedex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

EP 0 052 381 B1

**Description**

La présente invention a pour objet un procédé de préparation de compositions organopolysiloxaniques, liquides, stables au stockage, par réaction d'huiles α,ω-dihydroxydiorganopolysiloxaniques avec des alcoxysilanes portant des radicaux fonctionnels, liés aux atomes de silicium, choisis parmi les radicaux méthacroyloxyalcoyles, acroyloxyalcoyles et mercaptoalcoyles.

Elle a également pour objet des compositions organopolysiloxaniques, obtenues par mélange :

(1) soit des compositions précédentes, préparées à partir d'huiles α,ω-dihydroxydiorganopolysiloxaniques et d'alcoxysilanes à radicaux seulement méthacroyloxyalcoyles ou acroyloxyalcoyles (nommées par la suite compositions $E_1$) avec des alcoxysilanes à radicaux mercaptoalcoyles.

(2) soit des compositions précédentes, préparées à partir d'huiles α,ω-dihydroxydiorganopolysiloxaniques et d'alcoxysilanes à radicaux seulement mercaptoalcoyles, (nommées par la suite compositions $E_2$) avec des alcoxysilanes à radicaux méthacroyloxyalcoyles ou acroyloxyalcoyles.

(3) soit des compositions $E_1$ avec les compositions $E_2$.

Elle a encore pour objet des compositions sans solvants, photopolymérisables par les radiations ultraviolettes, constituées d'ingrédients choisis parmi les compositions $E_1$ et les compositions (1), (2) et (3), décrites ci-dessus, et de photosensibilisateurs.

Elle a, en outre, pour objet l'utilisation des compositions photopolymérisables précitées pour le traitement anti-adhérent de matériaux plus spécialement cellulosiques ou synthétiques.

Il est connu de fabriquer des compositions organopolysiloxaniques liquides par réaction de polymères organopolysiloxaniques hydroxylés avec des alcoxysilanes portant, liés aux atomes de silicium, des radicaux méthacroyloxyalcoyles ou acroyloxyalcoyles (brevets français 1 522 607, 2 110 115, brevet américain 3 782 940). Toutefois, les conditions opératoires des procédés mis en œuvre dans ces brevets sont mal définies de sorte qu'il n'est guère aisé d'obtenir avec certitude, des compositions utilisables sans solvants, stables au stockage ; bien souvent on aboutit à des compositions qui gélifient au stockage et/ou qui conduisent ultérieurement (après addition de photosensibilisateurs) à des revêtements dont l'anti-adhérence est tout juste moyenne et parfois médiocre, et cela malgré des temps d'exposition excessifs aux radiations, par exemple supérieurs à 50 secondes.

Des compositions de structure assez proche de celles des compositions précédentes, mais préparées en suivant un procédé différent, sont décrites dans la demande française 2 192 137. Ce procédé consiste à faire réagir, au sein de solvants aprotiques, et en présence de catalyseurs basiques, des alcoxysilanes à radicaux méthacroyloxyalcoyles ou acroyloxyalcoyles avec des organopolysiloxanes cycliques ou linéaires. Cette technique nécessite l'usage de solvants ce qui est toujours un inconvénient sur le plan industriel ; par ailleurs elle met en jeu une réaction de réarrangement des liaisons siloxaniques qui conduit à des mélanges complexes de polymères.

Des compositions photopolymérisables, utilisables pour le traitement anti-adhérent du papier, comportant, en dehors des photosensibilisateurs, des polymères diorganopolysiloxaniques ayant des radicaux organiques à insaturations éthyléniques, en particulier des radicaux méthacroyloxypropyles, figurent dans le brevet américain 3 726 710. Ces radicaux méthacroyloxypropyles sont fixés principalement le long de la chaîne des polymères diorganopolysiloxaniques et non en bout de chaîne. Pour introduire de tels radicaux le long de la chaîne il faut nécessairement utiliser une technique plus complexe que celle qui consiste à faire réagir des polymères α,ω-dihydroxydiorganopolysiloxaniques avec des alcoxysilanes à radicaux méthacroyloxypropyles. Le texte du brevet ne fournit guère de précisions sur les techniques envisageables ; néanmoins un processus faisant intervenir une réaction de substitution classique est parfaitement approprié.

Ainsi ce procédé peut consister à fabriquer, dans un premier temps, des polymères α,ω-bis(triorganosiloxy) diorganopolysiloxaniques (peu accessibles sur le marché des silicones) portant le long de la chaîne des radicaux chloroalcoyles liés aux atomes de silicium et à faire réagir ensuite, au sein de solvants et en présence d'accepteurs d'HCl, les radicaux chloroalcoyles avec les acides méthacryliques et acryliques. Un tel processus non seulement exige du temps, mais aussi beaucoup de soins pour atteindre un taux de substitution élevé.

Il est connu de fabriquer d'autres sortes de compositions organopolysiloxaniques liquides par réaction de polymères α,ω-dihydroxydiorganopolysiloxaniques avec des alcoxysilanes à radicaux mercaptoalcoyles (brevet américain 4 066 603). Dans ce processus les réactifs sont maintenus en contact en présence d'un catalyseur basique, tel que la potasse ou un silanolate de potassium, et l'alcool formé est totalement éliminé au cours d'une phase de dévolatilisation ; l'emploi de ce type de catalyseur implique, en fin de réaction, la mise en œuvre d'une phase de neutralisation (afin d'éviter une évolution des compositions au cours du stockage) et parfois d'une phase de filtration. Un tel processus est contraignant et demande à être amélioré.

Des compositions organopolysiloxaniques, photopolymérisables après addition de photosensibilisateurs, formés de polymères organopolysiloxaniques ayant des radicaux alcényles liés aux atomes de silicium, éventuellement de polymères organopolysiloxaniques ayant des liaisons SiH, et de silanes ou organopolysiloxanes ayant des radicaux mercaptoalcoyles, sont décrites dans de nombreux brevets (demandes françaises 2 245 729, 2 246 608, 2 257 736, 2 622 126). Ces compositions peuvent conduire à

des revêtements anti-adhérents efficaces ; cependant, elles ne possèdent pas encore tout un ensemble de qualités qui favoriserait leur développement industriel. Cet ensemble devrait comporter au moins les qualités suivantes : préparation aisée des divers constituants des compositions, bonne compatibilité des constituants entre eux, faible viscosité et durcissement rapide des compositions par exposition aux radiations ultraviolettes.

La présente invention se propose de remédier aux inconvénients précités. A cette fin, elle a pour objet, tout d'abord, un procédé de préparation de compositions organopolysiloxaniques stables au stockage, de viscosités allant de 60 mPa · s à 20 000 mPa · s à 25 °C, comportant des radicaux fonctionnels, liés aux atomes de silicium, choisis parmi les radicaux méthacroyloxyalcoyles, acroyloxyalcoyles et mercaptoalcoyles, selon lequel 1°) on met en contact :

A) des huiles α,ω-dihydroxydiorganopolysiloxaniques dont les radicaux organiques, liés aux atomes de silicium, sont choisis parmi les radicaux méthyles, éthyles, n-propyles, vinyles, phényles, trifluoropropyles, au moins 70 % de ces radicaux sont des radicaux méthyles, au plus 3 % sont des radicaux vinyles,

B) des silanes de formule générale $Z(G)SiR_a(Q)_{3-a}$ dans laquelle le symbole Z représente le radical, $CH_2{=}C(R')—COO$ ou le radical HS ; les symboles R, identiques ou différents, représentent des radicaux méthyles, éthyles, n-propyles, vinyles, phényles ; le symbole R' représente un atome d'hydrogène, un radical méthyle ; les symboles Q, identiques ou différents, représentent des radicaux méthoxyles, éthoxyles, n-propoxyles, des radicaux β-méthoxyéthoxyles, deux symboles Q en se réunissant représentent un radical de formule

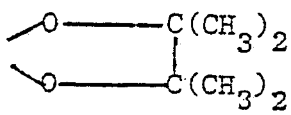

le symbole G représente un radical alcoylène, linéaire ou ramifié, ayant de 1 à 8 atomes de carbone ; le symbole a représente une valeur allant de zéro à 2,

C) des catalyseurs choisis parmi les titanates et polytitanates d'alcoyles et les sels de diorganoétain d'acides aliphatiques, à raison de 0,05 à 2 parties pour 100 parties du mélange des huiles A et des silanes B et 2°) laisse les 3 constituants A, B et C interréagir à une température s'échelonnant de 5 °C à 180 °C, ce procédé étant caractérisé par les points suivants :

i) les huiles A ont des viscosités qui s'étalent de 70 à 500 mPa · s à 25 °C,

ii) les huiles A et les silanes B sont mélangés en des proportions telles que le rapport molaire, radicaux hydroxyles des huiles/radicaux Q des silanes, s'étale de 0,1 à 0,95,

iii) les trois réactifs A, B et C sont maintenus en contact pendant le temps nécessaire pour éliminer, au plus, 45 % de la quantité théorique de l'alcool QH devant se former à partir des radicaux OH des huiles A et des radicaux Q des silanes B.

Selon une variante du iii) du procédé de l'invention, les trois réactifs A, B et C peuvent être aussi simplement maintenus en contact pendant au moins 10 heures, à une température s'étalant de 5 °C à 90 °C, sans élimination substantielle de l'alcool QH.

Les huiles α,ω-dihydroxydiorganopolysiloxaniques A ont une viscosité qui s'étale de 70 à 500 mPa · s à 25 °C, de préférence de 80 à 400 mPa · s à 25 °C ; ce sont des polymères linéaires constitués essentiellement de motifs diorganosiloxyles de formule $Y_2SiO$ et bloqués à chaque extrémité de leur chaîne par un radical hydroxyle ; toutefois la présence de motifs monoorganosiloxyles de formule $YSiO_{1,5}$ et/ou de motifs siloxyles de formule $SiO_2$ n'est pas exclue dans la proportion d'au plus 1 % par rapport au nombre des motifs diorganosiloxyles.

Les symboles Y, identiques ou différents, représentent des radicaux méthyles, éthyles, n-propyles, vinyles, phényles, trifluoro-3,3,3 propyles.

A titre illustratif de motifs représentés par la formule $Y_2SiO$ peuvent être cités ceux répondant aux formules suivantes : $(CH_3)_2SiO$ ; $CH_3(CH_2{=}CH)SiO$ ; $CH_3(C_2H_5)SiO$ ; $CH_3(n\text{-}C_3H_7)SiO$ ; $CH_3(CF_3CH_2\text{-}CH_2)SiO$ ; $CH_3(C_6H_5)SiO$ ; $(C_6H_5)_2SiO$.

Les huiles A sont généralement commercialisées par les fabricants de silicones. En outre elles peuvent être aisément fabriquées par simple hydrolyse de diorganodichlorosilanes ou de diorganodiacetoxysilanes dans un milieu aqueux renfermant un agent basique tel que l'ammoniaque ou le bicarbonate de sodium.

D'autres procédés peuvent être mis en œuvre, par exemple la polymérisation d'hexaorganocyclotrisiloxanes, à l'aide d'argile activée par un acide en milieu eau-acétone (brevet américain 3 853 932).

Les silanes B répondent soit à la formule $F_1$ : $CH_2{=}C(R')—COO(G)SiR_a(Q)_{3-a}$ lorsque Z représente le radical $CH_2{=}C(R')—COO$, soit à la formule $F_2$ : $HS(G)SiR_a(Q)_{3-a}$ lorsque Z représente le radical HS dans lesquelles les symboles R, R', Q, G et a ont la signification précédemment indiquée.

Plus précisément le symbole G représente un radical alcoylène, ayant de 1 à 8 atomes de carbone, choisi, par exemple, parmi ceux de formules : $—(CH_2)_n—$ (n = nombre entier allant de 1 à 8) ; $—CH_2CH(CH_3)CH_2—$ ; $—CH_2CH_2CH(CH_3)CH_2—$ ; $(CH_2)_4CH(C_2H_5)CH_2—$.

Comme exemples concrets de silanes de formule $F_1$ peuvent être cités ceux répondant aux formules suivantes : $CH_2{=}CH—COOCH_2Si(CH_3)(OCH_3)_2$ ; $CH_2{=}CH—COO(CH_2)_3Si(OC_2H_5)_3$ ; $CH_2{=}CH\text{-}$

$COO(CH_2)_3Si(OCH_3)_3$ ; $CH_2{=}CH{-}COO(CH_2)_4Si(OCH_2CH_2OCH_3)_3$ ; $CH_2{=}CH{-}COO(CH_2)_3Si(O\ n\text{-}C_3H_7)_3$ ; $CH_2{=}CH{-}COOCH_2CH(CH_3)CH_2Si(CH{=}CH_2)(OCH_3)_2$ ; $CH_2{=}C(CH_3)COOCH_2Si{-}CH_3(OCH_3)_2$ ; $CH_2{=}C(CH_3)COO(CH_2)_3Si(OCH_3)_3$ ; $CH_2{=}C(CH_3)COO(CH_2)_3Si(OC_2H_5)_3$ ; $CH_2{=}C(CH_3)COO(CH_2)_3Si(OCH_2OCH_3)_3$ ; $CH_2{=}C(CH_3)COO(CH_2)_3Si(CH_3)_2OCH_3$ ; $CH_2{=}C(CH_3)COO(CH_2)_4Si(C_6H_5)(OCH_3)_2$ ; $CH_2{=}C(CH_3)COO(CH_2)_4CH(C_2H_5)CH_2Si(C_2H_5)(OCH_3)_2$ ;

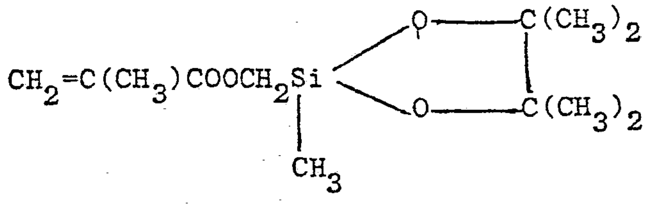

Ces silanes peuvent être préparés par réaction des composés intermédiaires de formule $Cl{-}C{-}SiR_a(Q)_{3-a}$ avec les acides organiques de formule $CH_2{=}C(R')COOH$. La réaction est avantageusement effectuée au sein d'un solvant aprotique tel que la N-méthylpyrrolidone-2, le N,N-diméthylformamide, et en présence d'un accepteur d'HCl tel que la triéthylamine. A la place des acides organiques peuvent être utilisés leurs sels de métaux alcalins ; dans ce cas il est inutile d'introduire un accepteur d'HCl dans le mélange réactionnel. Ces silanes peuvent également être achetés sur le marché des silicones.

Comme exemples concrets de silanes de formule $F_2$ peuvent être cités ceux répondant aux formules suivantes : $HS(CH_2)_3Si(OCH_3)_3$ ; $HSCH_2SiCH_3(OC_2H_5)_2$ ; $HS(CH_2)_4SiCH_3(OCH_3)_2$ ; $HS(CH_2)_4Si(CH_3)_2OC_2H_5$ ; $HSCH_2CH(CH_3)CH_2SiCH_3(OC_2H_5)_2$ ; $HS(CH_2)_3SiCH_3(OC_2H_5)_2$ ; $HS(CH_2)_3SiCH{=}CH_2(OC_2H_5)_2$ ; $HS(CH_2)_3SiC_6H_5(OCH_3)_2$ ; $HSCH_2CH(CH_3)CH_2Si(OC_2H_5)_3$.

Ces mercaptosilanes peuvent être préparés par décomposition des sels d'isothiouronium de formule :

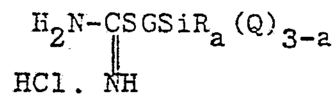

à l'aide d'un agent alcalin tel que l'ammoniac (brevet américain 3 314 982). Ils peuvent en outre être achetés sur le marché des silicones.

Les catalyseurs C sont choisis parmi les titanates et polytitanates d'alcoyles et les sels de diorganoétain d'acides aliphatiques, à raison de 0,05 à 2 parties, de préférence 0,1 à 1 partie pour 100 parties du mélange des huiles A avec les silanes B.

Les titanates d'alcoyles répondent à la formule générale $Ti[(OCH_2CH_2)_bOR'']_4$ dans laquelle les symboles R", identiques ou différents, représentent des radicaux alcoyles ayant de 1 à 8 atomes de carbone et le symbole b représente zéro ou 1 ; quand le symbole b représente zéro, les radicaux alcoyles renferment de 2 à 8 atomes de carbone tels que des radicaux éthyles, n-propyles, isopropyles, n-butyles, isobutyles, sec-butyles, n-pentyles, n-hexyles, éthyl-2 hexyles, n-heptyles, n-octyles, et quand le symbole b représente 1, les radicaux alcoyles sont des radicaux méthyles ou éthyles.

Comme exemples concrets de ces titanates d'alcoyles peuvent être cités les titanates d'éthyle, de n-propyle, d'isopropyle, de n-butyle, d'éthyl-2 hexyle, de β-méthoxyéthyle.

Les polytitanates d'alcoyles proviennent de l'hydrolyse partielle des titanates de formule $Ti(OR'')_4$ ; cette formule correspond à la formule précédente dans laquelle le symbole b représente zéro, le symbole R" représente donc un radical alcoyle ayant de 2 à 8 atomes de carbone.

Ces polytitanates comportent des structures linéaires, constituées chacune d'une succession de motifs de formule $-TiO(OR'')_2-$, et/ou de structures plus complexes commentées dans l'ouvrage « The Organic Chemistry of Titanium » de R. FELD et P. L. COWE, aux pages 25 à 31, édité par Butterworths London.

La conformation de ces polytitanates dépend étroitement des conditions opératoires de l'hydrolyse des titanates de formule $Ti(OR'')_4$, du rapport molaire titanates/eau d'hydrolyse et de la nature des radicaux R".

Cependant ces polytitanates doivent être stables au stockage et solubles dans les solvants hydrocarbonés usuels, tels que le toluène, le xylène, le cyclohexane, dans la proportion d'au moins 50 parties pour 100 parties de solvants.

Les sels de diorganoétains d'acides aliphatiques répondent à la formule $(R'''COO)_2SnT_2$ dans laquelle les R'", identiques ou différents, représentent des radicaux hydrocarbonés aliphatiques ayant de 1 à 25 atomes de carbone ; les symboles T, identiques ou différents, représentent des radicaux alcoyles ayant de 1 à 10 atomes de carbone.

Les radicaux hydrocarbonés aliphatiques, représentés par les symboles R'", englobent les radicaux

alcoyles et alcényles linéaires ou ramifiés. Comme exemples concrets de tels radicaux alcoyles peuvent être cités les radicaux méthyles, éthyles, n-propyles, isopropyles, n-butyles, n-hexyles, éthyl-2 hexyles, n-octyles, n-décyles, n-dodécyles, n-tétradécyles, n-pentadécyles, n-hexadécyles, n-octadécyles, n-eicosyles, n-docosyles, n-pentacosyles.

Comme exemples concrets de tels radicaux alcényles peuvent être cités les radicaux répondant aux formules :
$CH_3CH{=}CH{-}CH_2$ ; $CH_3CH{=}CH{-}(CH_2)_3$ ;
$CH_3{-}CH{=}CH(CH_2)_5$ ; $CH_3(CH_2)_4CH{=}CH(CH_2)_5$ ;
$CH_3(CH_2)_7CH{=}CH(CH_2)_8$ ;
$CH_3(CH_2)_4CH{=}CH{-}CH_2{-}CH{=}CH(CH_2)_8$-$CH_3(CH_2)_4{-}(CH{=}CH{-}CH_2)_4{-}(CH_2)_3$ ;

Par ailleurs, comme exemples concrets de radicaux alcoyles ayant de 1 à 10 atomes de carbone, représentés par les symboles T, peuvent être cités les radicaux méthyles, éthyles, isopropyles, n-propyles, n-butyles, isobutyles, n-pentyles, n-hexyles, n-octyles, n-décyles.

Les sels de diorganoétains d'acides aliphatiques peuvent être des produits purs ou des mélanges ; ces derniers sont préparés par exemple, par réaction de mélanges d'acides carboxyliques (provenant de glycérides naturels tels que les huiles de coprah, de palme) sur des oxydes de diorganoétain.

A titre illustratif de ces sels d'organoétains peuvent être mentionés ceux répondant aux formules :
$(CH_3{-}COO)_2Sn(n{-}C_4H_9)_2$ ;$[CH_3(CH_2)_{10}COO]_2Sn(n\text{-}C_4H_9)_2$ ; $[CH_3(CH_2)_{10}COO]_2Sn(CH_3)_2$ ;
$[CH_3(CH_2)_3CH(C_2H_5)COO]_2Sn(CH_3)_2$ ;
$[CH_3(CH_2)_3CH(C_2H_5)COO]_2Sn(n\text{-}C_4H_9)_2$ ;
$[CH_3(CH_2)_{12}COO]_2Sn(C_2H_5)_2$ ; $[CH_3(CH_2)_{14}COO]_2Sn(C_2H_5)_2$ ;
$[CH_3(CH_2)_7CH{=}CH(CH_2)_8]_2Sn(n\text{-}C_4H_9)_2$.

Pour réaliser le procédé conforme à l'invention on mélange tout d'abord les huiles A, les silanes B et les catalyseurs C selon les proportions indiquées.

Ainsi les quantités introduites des huiles A et des silanes B sont réparties d'une manière telle que le rapport molaire radicaux hydroxyles des huiles A/radicaux alcoxyles Q des silanes B, s'étale de 0,1 à 0,95, de préférence de 0,2 à 0,85. Une répartition conduisant à un rapport molaire inférieur à 0,1 n'a pas un grand intérêt car elle implique l'utilisation de quantités élevées de silanes B ; par ailleurs une répartition conduisant à un rapport molaire supérieur à 0,95 entraîne la formation de composition organopolysiloxaniques peu stables au stockage et/ou qui présentent après durcissement, une anti-adhérence médiocre.

Comme déjà indiqué les catalyseurs C sont introduits à raison de 0,05 à 2 parties, de préférence de 0,1 à 1 partie, pour 100 parties de l'ensemble huiles A + silanes B.

Les mélanges ainsi formés sont traités de la façon suivante :

les trois réactifs A, B et C sont maintenus en contact à une température s'étalant de 5 à 180 °C ; au cours de ce contact au plus 45 % de la quantité théorique de l'alcool QH, qui devrait se former sur la base des radicaux OH des huiles A et des radicaux alcoxyles Q des silanes B, présents dans les mélanges, sont éliminés. La durée de contact est fonction des moyens utilisés pour éliminer l'alcool ainsi que des conditions de chauffage. Elle est d'au moins 5 minutes, de préférence d'au moins 15 minutes, et peut dépasser plusieurs jours. En opérant à la pression atmosphérique, à des températures dépassant 100 °C, de l'ordre de 120 à 160 °C, tout en laissant partir au cours du chauffage au plus le pourcentage précité de l'alcool QH, les durées ne dépassent pas sensiblement 90 minutes. Ces durées peuvent être encore réduites et devenir, par exemple, inférieures à 60 minutes, en facilitant l'élimination de l'alcool QH à l'aide d'un courant gazeux inerte qui traverse le mélange réactionnel ou par utilisation d'une pression inférieure à la pression atmosphérique.

Il n'est pas recommandé de dépasser 180 °C de crainte d'obtenir des compositions de fortes viscosités, instables au stockage.

En opérant à des températures beaucoup plus basses, de l'ordre de 20 à 50 °C, il faut laisser les réactifs en contact au moins 48 heures ; la quantité requise d'alcool QH est alors éliminée, de préférence à la fin de la période de contact, par un léger chauffage sous une pression inférieure à la pression atmosphérique ou sous l'action seule d'une pression inférieure à la pression atmosphérique.

Si l'on élimine pendant ces processus plus de 45 % de la quantité théorique de l'alcool QH devant se former, les compositions obtenues risquent de gélifier au cours du stockage.

Suivant une variante du procédé ci-dessus décrit, les trois réactifs sont maintenus en contact au moins pendant 10 heures, à une température s'étalant de 5 °C à 90 °C et il n'y a pas, pendant cette durée, d'élimination de l'alcool QH. Ce mode de traitement est fort simple mais il nécessite des périodes de temps assez longues et d'autant plus longues que la température est plus basse. Vers 5 à 20 °C il faut laisser les réactifs en contact au moins pendant 72 heures mais vers 70-90 °C il ne faut plus qu'une dizaine d'heures.

Le choix du mode de traitement sera fonction des impératifs de fabrication (durée d'encombrement, moyens de chauffage et mode d'équipement des réacteurs) et de la nature de l'alcool QH. Un alcool volatif tel que le méthane ou l'éthanol demandera moins de calories pour être éliminé par chauffage du mélange réactionnel que le butanol ou même l'hexanol.

Les compositions obtenues selon ce procédé présentent une viscosité s'étalant de 60 mPa · s à 20 000 mPa · s à 25 °C, le plus souvent de 150 mPa · s à 15 000 mPa · s à 25 °C.

Elles sont stables au stockage en récipients fermés, opaques. La viscosité de certaines de ces

compositions peut cependant évoluer pendant quelques semaines après leur fabrication, période au cours de laquelle elle passe par exemple de 300 mPa · s à 25 °C à 1 000 mPa · s à 25 °C, mais par la suite elle se stabilise et n'évolue plus.

Du fait de leur procédé de préparation, ces compositions renferment, liés aux atomes de silicium, soit des radicaux fonctionnels méthacroyloxyalcoyles et/ou acroyloxyalcoyles apportés par les silanes de formule $F_1$, soit des radicaux mercaptoalcoyles apportés par des silanes de formule $F_2$.

Comme mentionné tout au début de la description, les compositions comportant des radicaux méthacroyloxyalcoyles et/ou acroyloxyalcoyles sont appelées compositions $E_1$ et celles comportant des radicaux mercaptoalcoyles sont appelées compositions $E_2$.

En dehors du procédé de préparation venant d'être exposé, compositions liquides (voyez EP-A 0 016 663) sont caractérisées en ce qu'elles sont obtenues :

— soit par mélange des compositions $E_1$ avec les silanes de formule $F_2$, les quantités respectives en présence des compositions $E_1$ et des silanes $F_2$ étant telles que le rapport molaire radicaux de formule $CH_2{=}C(R')COO$—, apportés par les compositions $E_1$/radicaux de formule HS—, apportés par les silanes $F_2$, soit supérieur à 0,05 et en pratique s'étale de 0,05 à 15, de préférence 0,2 à 12 ; ces compositions sont nommées $H_1$,

— soit par mélange des compositions $E_2$ avec les silanes de formule $F_1$, les quantités respectives en présence des compositions $E_2$ et des silanes $F_1$ étant telles que le rapport molaire radicaux de formule $CH_2{=}C(R')COO$—, apportés par les silanes $F_1$/radicaux de formule HS—, apportés par les compositions $E_2$ soit supérieur à 0,05 et en pratique s'étale de 0,05 à 15, de préférence de 0,1 à 8 ; ces compositions sont nommées $H_2$,

— soit par mélange des compositions $E_1$ avec les compositions $E_2$, les quantités respectives en présence des compositions $E_1$ et $E_2$ étant telles que le rapport molaire, radicaux de formule $CH_2{=}C(R')COO$—, apportés par les compositions $E_1$/radicaux HS—, apportés par les compositions $E_2$ soit supérieur à 0,5 et en pratique, s'étale de 0,05 à 15, de préférence de 0,1 à 10 ; ces compositions sont nommées $H_3$.

Ces compositions liquides présentent des viscosités qui s'échelonnent de 60 mPa · s à 25 °C à 20 000 mPa ·s à 25 °C, en général de 100 mPa · s à 15 000 mPa · s à 25 °C. Quand le rapport molaire $CH_2{=}C(R')COO/SH$ s'étale de 0,05 à 15, elles sont sensibles aux radiations et doivent être, de préférence, fabriquées au moment de leur emploi ; elles sont cependant stables au stockage en récipients fermés et opaques pendant environ 48 heures.

Chaque composition $H_1$, $H_2$ et $H_3$ peut être préparée par simple mélange, à la température ambiante et à la pression atmosphérique, des constituants venant d'être mentionnés. Ce processus n'exige donc pas de précautions particulières ; on peut néanmoins, lorsque l'un ou les deux constituants renferment des radicaux alcoxyles Q très sensibles à l'hydrolyse (tels que des radicaux méthoxyles) et que, en outre, l'air ambiant est très humide, effectuer le mélange sous atmosphère sèche mais cela n'est pas nécessaire dans la majorité des cas.

Dans la limite de leur compatibilité entre eux, les constituants des compositions $H_1$, $H_2$ et $H_3$ peuvent être mélangés en des proportions quelconques ; toutefois parmi les compositions en résultant, celles dont les rapports molaires, radicaux de formule $CH_2{=}C(R')COO$/radicaux de formule HS, se situent en dessous de la valeur 0,05 ne présentent que peu d'intérêt pour le traitement anti-adhérent de matériaux les plus divers.

En effet les compositions $H_1$, $H_2$ et $H_3$ sont destinées principalement, après addition de photosensibilisateurs, à être déposées en couches minces sur des supports plats cellulosiques ou synthétiques ; ces couches sont ensuite durcies par exposition à des radiations et plus spécialement aux radiations ultraviolettes. On recherche donc des revêtements ayant une bonne anti-adhérence vis-à-vis des substances collantes, poisseuses, visqueuses ou humides.

En dehors des compositions $H_1$, $H_2$ et $H_3$, sont utilisables, pour la même application industrielle de traitement anti-adhérent, les compositions $E_1$ mais non les compositions $E_2$ ; ces dernières, après addition de photosensibilisateurs et durcissement par exposition aux radiations, ne permettent pas toujours d'obtenir des revêtements anti-adhérents ayant une bonne résistance au gommage.

La présente invention a donc également pour objet des compositions photopolymérisables, par exposition aux radiations ultraviolettes, caractérisées en ce qu'elles comportent 100 parties de compositions choisies parmi les compositions $E_1$, $H_1$, $H_2$ et $H_3$ et 0,1 à 10 parties, de préférence 0,2 à 8 parties, de photosensibilisateurs (ou de photo-initiateurs).

Ces compositions photopolymérisables sont obtenues par simple mélange, à la température ambiante et à la pression atmosphérique, des compositions $E_1$, $H_1$, $H_2$ ou $H_3$ avec les photosensibilisateurs. La durée de brassage des compositions avec les photosensibilisateurs est fonction des quantités introduites des photosensibilisateurs et de leur solubilité au sein des compositions. Généralement il faut une période de temps de 30 minutes à 3 heures.

Les photosensibilisateurs sont choisis de préférence parmi les dérivés de la benzoïne, de la xanthone et de la thioxanthone.

A titre d'exemples concrets de tels photosensibilisateurs peuvent être cités :

les éthers ou mélanges d'éthers alcoyliques de la benzoïne (le radical alcoyle renferme de 1 à 6 atomes de carbone) tels que les éthers n-propyliques, isopropyliques, n-butyliques, isobutyliques,

la chloro-3 xanthone, la méthoxy-3 xanthone, la chloro-2 thioxanthone.

D'autres types de photosensibilisateurs peuvent être aussi employés comme les dérivés de cétones aromatiques par exemple l'acétophénone, la benzophénone, la bis(diméthylamino)-4,4' benzophénone. Cependant ces derniers composés donnent parfois de moins bons résultats que les précédents ou alors il faut leur adjoindre un coinitiateur (par exemple la triéthylamine, la phosphite de triéthyle).

Les compositions photopolymérisables sont utilisées plus spécialement, comme déjà indiqué, pour le traitement anti-adhérent de feuilles en matériaux cellulosiques ou synthétiques. Dans ce cas elles sont déposées, à raison de 0,5 à 5 g/m², sur ces surfaces à l'aide de dispositifs employés sur les machines industrielles. Ces dispositifs sont constitués bien souvent, de plusieurs cylindres placés les uns au-dessus des autres, le cylindre inférieur étant en contact avec les compositions à déposer et le cylindre supérieur avec les surfaces à traiter (demande française 2 207 811).

Les compositions photopolymérisables (ainsi déposées sous forme de couches minces), sont durcies par exposition à des radiations ultraviolettes fournies par des lampes à xénon ou à arc à mercure dont le spectre d'émission s'étale environ de 250 à 450 nm. Le temps d'exposition est très court ; il est inférieur à 30 s, de préférence à 20 s, et peut être seulement de 1 s. Le temps d'exposition est particulièrement court avec les compositions $H_1$, $H_2$ et $H_3$ dont le rapport molaire des radicaux $CH_2{=}C(R')COO/SH$ s'étale de 0,05 à 15. En d'autres termes la présence de radicaux SH contribue à réduire ce temps d'exposition.

Toutefois les compositions photopolymérisables de l'invention peuvent être appliquées sur tous les matériaux qui sont, ou seront, en contact avec des substances collantes, visqueuses, pâteuses ou libérant de l'humidité. Ces matériaux sont de nature et d'origine diverses. Ils comprennent les diverses variétés de papier (comme le papier Kraft dont le degré de raffinage peut être quelconque, le papier cristal, les papiers sulfurisés), les cartons, le parchemin végétal, les papiers enduits de polyéthylène ou de carboxyméthylcellulose, les feuilles en cellulose régénérée (comme la « Cellophane ») ou en acétate de cellulose, les feuilles en matières plastiques telles celles en polyéthylène, polypropylène, polytéréphtalate d'éthylène, les feuilles en métal, les tissus à base de fibres synthétiques, de verre ou d'amiante, les matériaux fibreux non tissés, qu'ils soient à base de fibres cellulosiques ou de fibres synthétiques ou d'un mélange de ces fibres.

Les matériaux rendus ainsi anti-adhérents sont utilisés comme intercalaires, supports séparateurs, papiers et pellicules pour transferts, emballages 1) de matières collantes telles que la confiserie, la pâtisserie, les caoutchoucs crus, les brais et bitumes, les cires ou 2) de matières alimentaires libérant de l'humidité telles que le poisson, la viande, le fromage.

Les exemples suivants illustrent l'invention.

Les parties et les pourcentages sont exprimés en poids :

## Exemple 1

a) On charge dans un réacteur, équipé d'un agitateur, d'une gaine thermométrique et d'un col de cygne surmonté d'un analyseur :

95,4 parties d'une huile α,ω-dihydroxydiméthylpolysiloxanique de viscosité sensiblement 100 mPa · s à 25 °C, renfermant 0,7 % de groupes hydroxyles.

4,6 parties du silane de formule : $CH_2{=}C(CH_3)COO(CH_2)_3Si(OCH_3)_3$ et 0,2 partie du titanate de tétraisopropyle.

Le rapport molaire radicaux OH de l'huile/radicaux $OCH_3$ du silane est d'environ 0,7.

Le contenu du réacteur est chauffé progressivement de 23 °C à 150 °C en une période de 28 minutes ; au cours de ce chauffage, 0,19 partie de méthanol est recueillie dans un collecteur faisant suite à l'analyseur. Etant donné que la quantité théorique attendue de méthanol est de 1,26 partie, le pourcentage extrait représente environ 15 % de cette quantité. Le liquide limpide obtenu a une viscosité de 1 000 mPa · s à 25 °C.

b) On ajoute à 100 parties du liquide préparé ci-dessus, 4 parties d'un photo-initiateur constitué d'un mélange des éthers butylique et isobutylique de la benzoïne (distribués pratiquement dans le rapport pondéral 50/50) et agite l'ensemble à la température ambiante pendant 2 heures.

Le mélange obtenu est ensuite déposé, à raison de 2 g/m², sur un papier Kraft (prépare à partir d'une pâte blanchie, raffinée à 64° Shopper) pesant 67 g/m², surfacé à l'aide de polymères cellulosiques et supercalendré.

Le dépôt est exécuté à l'aide d'un système d'enduction comportant principalement 3 cylindres disposés les uns au-dessus des autres. Le cylindre le plus bas plonge dans un bac rempli du mélange à déposer sur le papier et imprègne de ce mélange le cylindre de report placé au-dessus de lui ; ce cylindre de report imprègne à son tour un cylindre enducteur qui est maintenu en permanence en contact avec la feuille de papier.

La couche de silicone, appliquée sur le papier, est durcie par exposition pendant 10 secondes aux radiations ultraviolettes. Ces radiations sont émises par une lampe, sans réflecteur, à vapeur de mercure et d'iodures métalliques, dont la zone frontale est située à une distance de 1 cm de la surface du papier ; le spectre d'émission s'étale de 275 à 450 nm avec un maximum entre 360 et 380 nm. La puissance reçue par l'échantillon est de l'ordre de 9,4 à 9,8 W/cm².

On constate, par frottement du doigt sur la face enduite du papier, qu'il n'y a pas de traces de gommage ; ainsi la couche est convenablement durcie, elle ne migre pas.

D'autre part, on fabrique des éprouvettes en découpant, tout d'abord, des échantillons de dimensions 200 × 50 mm dans le papier enduit de silicone. Sur chaque échantillon est ensuite appliqué, du côté de la face enduite, un ruban adhésif de dimensions 150 × 19 mm.

Les éprouvettes sont placées sur une plaque métallique puis abandonnées pendant 20 h à 70 °C ; pendant cette période elles sont soumises à une pression de 18 g/cm$^2$ par mise en place, sur toute leur surface, de plaquettes d'acier.

A la suite de ce traitement, les éprouvettes sont exposées pendant 1 heure à l'air ambiant, la température étant de 20 °C environ. Le ruban adhésif de chaque éprouvette est alors décollé de la surface du papier par traction à l'aide d'un dynamomètre, la vitesse de décollement étant de 200 mm/minute. On relève une force de décollement de 12 g pour 1 cm de largeur du ruban. Cette valeur démontre le bon caractère anti-adhérent apporté par le revêtement de silicone.

## Exemple 2

On prépare 8 essais en reproduisant le mode opératoire décrit dans la partie (a) de l'exemple 1 ; toutefois on fait varier les quantités respectives de l'huile α,ω-dihydroxydiméthylpolysiloxanique de viscosité 100 mPa · s à 25 °C et du silane de formule $CH_2=C(CH_3)COO(CH_2)_3Si(OCH_3)_3$ ainsi que le mode de chauffage des 3 réactifs. On maintient, pour chaque essai, l'incorporation de 0,2 partie du titanate de tétraisopropyle.

Les données relatives à la réalisation de ces essais, et à la viscosité des compositions formées, figurent dans le tableau I ci-après :

(Voir Tableau I page 9)

Tableau I

| Essais | Huile Quantité en parties | Silane Quantité en parties | Rapport Molaire $OH/OCH_3$ | Mode de Chauffage | Quantité extraite de méthanol en % par rapport à la quantité théorique | Viscosité en mPa.s à 25°C des compositions obtenues: À la sortie du réacteur | Viscosité en mPa.s à 25°C des compositions obtenues: Au bout de 30 jours de conditionnement en récipient fermé, opaque |
|---|---|---|---|---|---|---|---|
| $d_1$ | 97,9 | 2,1 | 1,5 | de 23 à 160°C en 40 min. | 10 | 330 | gelifié |
| $d_2$ | 96,6 | 3,4 | 0,95 | de 23 à 160°C en 25 min. | 19 | 600 | 2 500 |
| $d_3$ | 95,4 | 4,6 | 0,7 | à 23°C pendant 96 h. | zéro | 350 | 1 000 |
| $d_4$ | 95,4 | 4,6 | 0,7 | de 23 à 90°C en 30 min. + 1h à 90°C | 1,9 | 360 | 1 000 |
| $d_5$ | 95,4 | 4,6 | 0,7 | de 23 à 160°C en 60 min. | 50 | 2400 | gélifié |
| $d_6$ | 93,8 | 6,2 | 0,5 | de23 à 140°C en 30 min. | 15 | 450 | 2 000 |
| $d_7$ | 90,1 | 9,9 | 0,3 | de 23 à 140°C en 30 min. | 11 | 200 | 240 |
| $d_8$ | 75,1 | 24,9 | 0,1 | de 23 à 150°C en 40 min. | 15 | 240 | 300 |

Le caractère anti-adhérent apporté par le dépôt puis le durcissement de ces diverses compositions sur du papier est mesuré en suivant le mode opératoire de la partie b de l'exemple 1.

On constate que toutes les compositions procurent une bonne anti-adhérence durable (pas de gommage avec le doigt et force de décollement inférieure à 20 g/cm) sauf celles des essais $d_1$ et $d_5$. Ces deux compositions ne sont pas stables au stockage, en outre elles durcissent mal par exposition aux radiations ultraviolettes ; elles nécessitent, en effet, une durée d'exposition de 90 s au lieu de 25 à 10 s pour les autres compositions tout en fournissant des résultats d'anti-adhérence médiocres (gommage avec le doigt).

## Exemple 3

On charge dans le réacteur utilisé à l'exemple 1 :

93 parties d'une huile α,ω-dihydroxydiméthylpolysiloxanique de viscosité sensiblement 100 mPa · s à 25 °C, renfermant 0,7 % de groupes hydroxyles.

7 parties d'un silane de formule

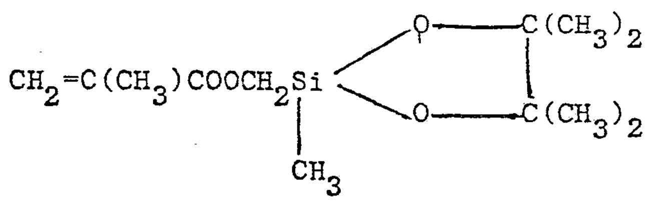

0,2 partie du titanate d'isopropyle

Le rapport molaire radicaux OH de l'huile/radicaux

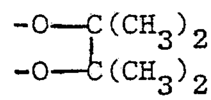

du silane est d'environ 0,7 (on compte 2 radicaux SiOH pour un radical

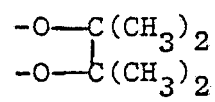

Le contenu du réacteur est porté de 23 °C à 140 °C en une période de 35 minutes ; il est ensuite maintenu à cette température pendant 30 minutes.

On recueille pendant ce traitement quelques traces d'eau mais pas de traces de diol de formule

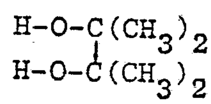

Le liquide limpide obtenu à une viscosité de 315 mPa · s à 25 °C.

On opère alors selon la partie b de l'exemple 1 et traite ainsi le papier Kraft pesant 67 g/m² avec un mélange comprenant 100 parties du liquide ci-dessus et 4 parties du mélange précité d'esters butylique et isobutylique de la benzoïne. On constate que la couche de silicone, durcie par exposition pendant 20 s aux radiations ultraviolettes, résiste au gommage et que la force nécessaire pour décoller le ruban adhésif du papier est de l'ordre de 15 g/cm.

## Exemple 4

On réalise 3 essais en reproduisant le mode opératoire décrit dans la partie (a) de l'exemple 1 ; toutefois on remplace l'huile α,ω-dihydroxydiméthylpolysiloxanique de viscosité 100 mPa · s à 25 °C par l'une quelconque des 3 huiles α,ω-dihydroxydiméthylpolysiloxaniques $A_1$, $A_2$ et $A_3$, ayant les caractéristiques ci-après :

$A_1$, viscosité 60 mPa · s à 25 °C, ayant 3,7 % de groupes OH

$A_2$, viscosité 500 mPa · s à 25 °C, ayant 0,40 % de groupes OH

$A_3$, viscosité 750 mPa · s à 25 °C, ayant 0,3 % de groupes OH.

Les données relatives à la réalisation de ces essais, en particulier les quantités respectives des huiles $A_1$, $A_2$, $A_3$ et du silane de formule $CH_2{=}C(CH_3)COO(CH_2)_3Si(OCH_3)_3$ ainsi que la viscosité des compositions formées, figurent dans le tableau II ci-après.

Pour chaque essai, le titanate d'isopropyle est utilisé à la dose de 0,2 partie pour 100 parties de l'ensemble huile + silane ; par ailleurs, le rapport molaire, radicaux SiOH de chaque huile/radicaux $OCH_3$ du silane, reste constant (de l'ordre de 0,7).

Tableau II

| Essais | Nature de l'huile et quantité utilisée | Quantité de Silane | Mode de Chauffage | Quantité extraite de méthanol en % par rapport à la théorie | Viscosité en mPa.s à 25°C des compositions obtenues | |
|---|---|---|---|---|---|---|
| | | | | | à la sortie du réacteur | au bout de 30jours en récipient fermé, opaque |
| $e_1$ | $(A_1)$ 79,3 | 20,7 | de 23°C à 160°C en 40 minutes | 26 | 50 | 250 |
| $e_2$ | $(A_2)$ 95,4 | 4,60 | de 23°C à 145°C en 49 minutes | 4,8 | 5 000 | 10 000 |
| $e_3$ | $(A_3)$ 98,06 | 1,94 | de 23°C à 145°C en 49 minutes | traces | 35 000 | gélification |

Le caractère anti-adhérent, apporté par le dépôt puis le durcissement des compositions des essais $e_1$, $e_2$ et $e_3$, sur du papier est mesuré en suivant le mode opératoire de la partie (b) de l'exemple 1. On constate que :

l'emploi de l'huile $A_1$, dans l'essai $e_1$, conduit à une anti-adhérence médiocre puisque la force de décollement est de 80 g/cm, en outre la réticulation nécessite un temps d'exposition assez long (45 s),

l'emploi de l'huile $A_2$, dans l'essai $e_2$, conduit à une anti-adhérence correcte, la force de décollement est de 30 g/cm pour une durée de réticulation de 20 s,

l'emploi de l'huile $A_3$, dans l'essai $e_3$, conduit à une mauvaise anti-adhérence bien que la durée de réticulation soit de 55 s : le revêtement est facilement enlevé par gommage ; de plus la composition gélifie rapidement au stockage.

Essai 1

On utilise la composition de viscosité 350 mPa · s à 25 °C (figurant sous le numéro d'essai $d_3$ dans le tableau I de l'exemple 2) préparée par agitation, à la température ambiante, pendant 96 h, de l'huile α,ω-dihydroxydiméthylpolysiloxanique de viscosité 100 mPa · s à 25 °C avec le silane de formule $CH_2=C(CH_3)COO(CH_2)_3Si(OCH_3)_3$ en présence du titanate d'isopropyle.

On associe à cette composition, nommée par la suite $P_1$, des quantités variables du mercaptosilane de formule $HS(CH_2)_3Si(OCH_3)_3$ de manière à obtenir, pour chaque nouvelle composition formée, un rapport molaire radicaux $CH_2=C(CH_3)COO$/radicaux HS, différent. On ajoute également des quantités variables du photo-initiateur utilisé dans la partie (b) de l'exemple 1. On détermine ensuite, selon la technique enseignée également dans la partie (b) de l'exemple 1, la durée d'exposition aux radiations ultraviolettes permettant un caractère anti-adhérent efficace et durable (pas de gommage et une force de décollement inférieure à 30 g/cm).

Les données relatives à la proportion des constituants des nouvelles compositions ainsi que les durées de photoréticulation sont consignées dans le tableau III ci-après :

(Voir Tableau III page 13)

Tableau III

| Essais | Constitution de chaque nouvelle composition | | Rapport molaire $CH_2=C(CH_3)COO$ / sur HS | Quantité du photo-initiateur | Durée d'exposition aux radiations ultraviolettes, en secondes |
|---|---|---|---|---|---|
| | Quantité de la Composition $P_1$ | Quantité du mercaptosilane | | | |
| $f_1$ | 100 | 0 | | 4 | 10 |
| $f_{1'}$ | 100 | 0 | | 1 | 20 |
| $f_2$ | 99,6 | 0,4 | 9 | 4 | 4 |
| $f_{2'}$ | 99,6 | 0,4 | 9 | 1 | 20 |
| $f_3$ | 98,8 | 1,2 | 3 | 4 | 2 |
| $f_{3'}$ | 98,8 | 1,2 | 3 | 1 | 10 |
| $f_4$ | 96,3 | 3,7 | 1 | 4 | 2 |
| $f_{4'}$ | 96,3 | 3,7 | 1 | 1 | 8 |
| $f_5$ | 88,7 | 11,3 | 0,3 | 4 | 2 |
| $f_{5'}$ | 88,7 | 11,3 | 0,3 | 1 | 2 |

De ces résultats il ressort que l'introduction du mercaptosilane est bénéfique ; ainsi elle permet d'une part, de réduire notablement les durées d'exposition aux radiations et d'autre part de choisir de faibles quantités du photo-initiateur.

Essai 2

(a1) On charge dans le réacteur utilisé à l'exemple 1 :

96,3 parties d'une huile α,ω-dihydroxydiméthylpolysiloxanique de viscosité sensiblement 100 mPa · s à 25 °C, renfermant 0,7 % de groupes hydroxyles,

3,7 parties d'un silane de formule $HS(CH_2)_3Si(OCH_3)_3$

0,2 partie du titanate d'isopropyle.

Le rapport molaire radicaux OH de l'huile/radicaux $OCH_3$ du mercaptosilane est d'environ 0,7.

Le contenu du réacteur est agité pendant 96 h à la température ambiante. Il en résulte la formation d'une composition, nommée par la suite $P_2$, limpide, de viscosité 300 mPa · s à 25 °C ; cette viscosité atteint 1 000 mPa · s à 25 °C au bout de 30 jours de conditionnement en récipient fermé, elle se stabilise ensuite à cette valeur.

On associe à cette composition $P_2$, des quantités variables du méthacroyloxysilane de formule $CH_2{=}C(CH_3)COO(CH_2)_3Si(OCH_3)_3$ de manière à avoir, pour chaque nouvelle composition formée, un rapport radicaux $CH_2{=}C(CH_3)COO$—/radicaux HS — différent. On ajoute également des quantités variables du photo-initiateur utilisé dans la partie (b) de l'exemple 1. On mesure ensuite la durée d'exposition qui permet d'obtenir une anti-adhérence efficace et durable caractérisée par une bonne résistance au gommage et une force de décollement inférieure à 30 g/cm.

Les données relatives à la constitution des nouvelles compositions ainsi que les durées de photoréticulation sont rassemblées dans le tableau IV ci-après :

(Voir Tableau IV page 15)

Tableau IV

| Essais | Constitution de chaque nouvelle composition | | Rapport molaire radicaux $CH_2=C(CH_3)COO-$ radicaux HS | Quantité du Photo-initiateur | Durée d'exposition aux radiations ultra-violettes en secondes |
|---|---|---|---|---|---|
| | Quantité de la composition $P_2$ | Quantité du méthacroyloxysilane | | | |
| g | 100 | 0 | | 0 | 10 |
| g' | 100 | 0 | | 4 | 10 |
| $g_1$ | 98,6 | 1,4 | 0,3 | 4 | 5 |
| $g_1'$ | 98,6 | 1,4 | 0,3 | 1 | 6 |
| $g_2$ | 95,5 | 4,5 | 1 | 4 | 1 |
| $g_2'$ | 95,5 | 4,5 | 1 | 1 | 7 |
| $g_3$ | 87,6 | 12,4 | 3 | 4 | 6 |
| $g_3'$ | 87,6 | 12,4 | 3 | 1 | 7 |
| $g_4$ | 70,2 | 29,8 | 9 | 4 | 6 |
| $g_4'$ | 70,2 | 29,8 | 9 | 1 | 12 |

Les revêtements obtenus à partir des compositions des essais g et g', se laissent assez facilement enlever par frottement avec le doigt bien que la force de décollement du ruban adhésif, déposé sur leur surface, soit inférieure à 30 g/cm.

Il ressort de ce tableau que la présence du méthacroyloxysilane est nécessaire pour avoir une bonne résistance au gommage ; elle permet en outre de réduire la durée de photoréticulation ; les meilleurs résultats sont réalisés avec les compositions des essais $g_2$ et $g_2'$, ces compositions présentant un rapport molaire radicaux $CH_2{=}C(CH_3)COO$/radicaux HS, de l'ordre de 1.

(b1) A titre comparatif on reproduit le mode opératoire décrit dans le paragraphe (a1) ci-dessus excepté que sont mises en œuvre 97,4 parties de l'huile α,ω-dihydroxydiméthylpolysiloxanique de viscosité 100 mPa · s à 25 °C et 2,6 parties du silane de formule $HS(CH_2)_3Si(OCH_3)_3$. Ces quantités définissent un rapport molaire radicaux OH de l'huile/radicaux $OCH_3$ du mercaptosilane d'environ 1.

La composition obtenue a une viscosité de 425 mPa · s à 25 °C.

On associe à 75,3 parties de cette composition 24,7 parties du méthacroyloxysilane précité établissant ainsi un rapport molaire radicaux $CH_2{=}C(CH_3)COO$—/radicaux HS- de l'ordre de 1.

On ajoute à 200 parties de ce mélange 4 parties du photo-initiateur utilisé dans la partie (b) de l'exemple 1 et soumet l'ensemble aux radiations ultraviolettes. On constate pour une durée d'exposition de 20 secondes, que la couche de silicone durcie ne résiste pas au gommage avec le doigt ; il en résulte, au vu des résultats exposés dans le tableau IV, qu'il est nécessaire de mettre en œuvre (avant d'ajouter le méthacroyloxysilane) une composition de départ présentant un rapport molaire radicaux OH de l'huile/radicaux $OCH_3$ du mercaptosilane inférieur à 1.

Egalement à titre comparatif on reproduit le mode opératoire décrit ci-dessus en (a1) sauf qu'on utilise 98,4 parties d'une huile α,ω-dihydroxydiméthylpolysiloxanique de viscosité 750 mPa · s à 25 °C, ayant 0,3 % de groupes OH, à la place de l'huile de viscosité 100 mPa · s à 25 °C et 1,6 partie du silane de formule $HS(CH_2)_3Si(OCH_3)_3$, le rapport molaire radicaux OH de l'huile/radicaux $OCH_3$ du mercaptosilane étant toujours de 0,7.

On constate que le liquide formé, de viscosité 30 000 mPa · s à 25 °C, n'est pas stable au stockage ; en particulier il gélifie au bout d'une dizaine de jours de conditionnement en récipient fermé, à la température ambiante. Il en résulte, au vu de la stabilité présentée par la composition $P_2$, qu'il est nécessaire d'utiliser une huile de viscosité inférieure à 750 mPa · s.

## Essai 3

On fabrique plusieurs compositions par simple mélange à la température ambiante, de quantités variables de la composition $P_1$ (décrite à l'exemple 5), préparée à partir de l'huile α,ω-dihydroxydiméthylpolysiloxanique de viscosité 100 mPa · s à 25 °C et du méthacroyloxysilane de formule $CH_2{=}C(CH_3)COO(CH_2)_3Si(OCH_3)_3$, avec la composition $P_2$ (décrite à l'exemple 6), préparée à partir de la même huile α,ω-dihydroxydiméthylpolysiloxanique et du mercaptosilane de formule $HS(CH_2)_3Si(OCH_3)_3$.

On détermine l'efficacité de chaque composition, sur le plan de l'anti-adhérence, en suivant le processus indiqué à la partie (b) de l'exemple 1 : on incorpore à chaque composition deux quantités différentes du photo-initiateur formé par mélange pondéral 50/50 des éthers butylique et isobutylique de la benzoïne et on soumet chaque nouveau mélange à des radiations ultraviolettes émises par l'appareillage décrit à la partie (b) de l'exemple 1. On mesure ensuite les durées d'exposition qui permettent d'obtenir une bonne anti-adhérence se conservant dans le temps (d'une part résistance du revêtement au gommage par le doigt, et d'autre part force de décollement du ruban adhésif inférieur à 30 g/cm).

Les données relatives à la constitution des compositions et aux durées de réticulation sont rassemblées dans le tableau V ci-après :

(Voir Tableau V page 17)

Tableau V

| Essais | Constitution de chaque nouvelle composition: Quantité de la composition $F_1$ | Constitution de chaque nouvelle composition: Quantité de la composition $P_2$ | Rapport molaire: radicaux $CH_2=C(CH_3)COO$ / radicaux HS | Quantité du Photo-initiateur | Durée de la photoréticulation |
|---|---|---|---|---|---|
| K | 100 | 0 | | 4 | 8 |
| K' | 0 | 100 | | 0 | 10 |
| $K_1$ | 22,5 | 77,5 | 0,3 | 4 | 1 |
| $K_1$' | 22,5 | 77,5 | 0,3 | 1 | 4 |
| $K_2$ | 49,1 | 50,9 | 1 | 4 | 1 |
| $K_2$' | 49,1 | 50,9 | 1 | 1 | 2 |
| $K_3$ | 74,3 | 25,7 | 3 | 4 | 3 |
| $K_3$' | 74,3 | 25,7 | 3 | 1 | 6 |
| $K_4$ | 89,7 | 10,3 | 9 | 4 | 12 |
| $K_4$' | 89,7 | 10,3 | 9 | 1 | 24 |

Il y a lieu de noter que dans le cas de l'essai K' la couche déposée ne résiste pas au gommage par le doigt.

Des résultats exposés dans le tableau, il ressort que les compositions mixtes dont le rapport molaire radicaux $CH_2=C(CH_3)COO$/radicaux HS, s'étale de 0,3 à 3 sont réticulées en des temps très courts avec une faible quantité de photo-initiateur.

**Revendications**

1. Procédé de préparation de compositions organopolysiloxaniques stables au stockage, de viscosités allant de 60 mPa · s à 20 000 mPa ≥ à 25 °C, comportant des radicaux fonctionnels, liés aux atomes de silicium, choisis parmi les radicaux méthacroyloxyalcoyles, acroyloxyalcoyles et mercaptoalcoyles selon lequel 1) on met en contact :

A) des huiles α,ω-dihydroxydiorganopolysiloxaniques dont les radicaux organiques, liés aux atomes de silicium, sont choisis parmi les radicaux méthyles, éthyles, n-propyles, vinyles, phényles, trifluoropropyles, au moins 70 % de ces radicaux sont des radicaux méthyles, au plus 3 % sont des radicaux vinyles,

B) des silanes de formule générale $Z(G)SiR_a(Q)_{3-a}$ dans laquelle le symbole Z représente le radical $CH_2=C\ (R')—COO$ ou le radical HS ;

Les symboles R, identiques ou différents, représentent des radicaux méthyles, éthyles, n-propyles, vinyles, phényles ; le symbole R' représente un atome d'hydrogène, un radical méthyle ; les symboles Q, identiques ou différents, représentent des radicaux méthoxyles, éthoxyles, n-propoxyles, des radicaux β-méthoxyéthoxyles, deux symboles Q en se réunissant représentent un radical de formule :

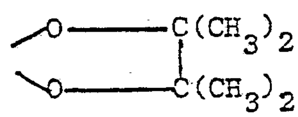

le symbole G représente un radical alcoylène, linéaire ou ramifié, ayant de 1 à 8 atomes de carbone ; le symbole a représente une valeur allant de 0 à 2,

C) des catalyseurs choisis parmi les titanates et polytitanates d'alcoyles et les sels de diorganoétain d'acides aliphatiques, à raison de 0,05 à 2 parties pour 100 parties du mélange des huiles A et des silanes B, et 2) laisse les 3 constituants A, B et C interréagir à une température s'échelonnant de 5 °C à 180 °C, ce procédé étant caractérisé par les points suivants :

i) les huiles A ont des viscosités qui s'étalent de 70 à 500 mPa · s à 25 °C,

ii) les huiles A et les silanes B sont mélangés en des proportions telles que le rapport molaire radicaux hydroxyles des huiles/radicaux Q des silanes, s'étale de 0,1 à 0,95,

iii) les trois réactifs A, B et C sont maintenus en contact pendant le temps nécessaire pour éliminer, au plus, 45 % de la quantité théorique de l'alcool QH devant se former à partir des radicaux OH des huiles A et des radicaux Q des silanes B.

2. Procédé selon la revendication 1, dans lequel les trois réactifs A, B et C sont simplement maintenus en contact pendant au moins 10 heures, à une température s'étalant de 5 °C à 90 °C, sans élimination substantielle de l'alcool QH.

3. Compositions photopolymérisables par les radiations ultraviolettes comprenant pour 100 parties en poids des compositions selon les revendications 1 ou 2 dans lesquelles le symbole Z représente le radical $CH_2=C\ (R')COO$, 0,1 à 10 parties d'un photosensibilisateur choisi parmi des dérivés de la benzoïne, de la xanthone ou de la thioxanthone.

4. Emploi des compositions selon la revendication 3 au traitement anti-adhérent de matières solides.

**Claims**

1. Process for preparing organopolysiloxane compositions stable on storage, of viscosities ranging from 60 mPa · s to 20,000 mPa · s at 25 °C, containing functional radicals, bound to the silicon atoms, chosen from methacryloyloxyalkyl, acryloyloxyalkyl and mercaptoalkyl radicals, according to which 1) the following are brought into contact :

A) α,ω-dihydroxydiorganopolysiloxane oils in which the organic radicals bound to the silicon atoms are chosen from methyl, ethyl, n-propyl, vinyl, phenyl and trifluoropropyl radicals, at least 70 % of these radicals are methyl radicals and at most 3 % are vinyl radicals,

B) silanes of general formula $Z(G)SiR_a(Q)_{3-a}$ in which the symbol Z denotes a $CH_2=C\ (R')—COO$ radical or an HS radical ; the symbols R, which may be identical or different, denote methyl, ethyl, n-propyl, vinyl or phenyl radicals ; the symbol R' denotes a hydrogen atom or methyl radical ; the symbols Q, which may be identical or different, denote methoxyl, ethoxyl, n-propoxyl radicals or β-methoxyethoxyl radicals, two symbols Q uniting denote a radical of formula :

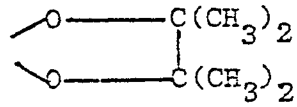

the symbol G denotes a linear or branched alkylene radical having from 1 to 8 carbon atoms ; and the symbol a denotes a value ranging from 0 to 2,

C) Catalysts chosen from alkyl titanates and polytitanates and diorganotin salts of aliphatic acids, in the proportion of 0.05 to 2 parts per 100 parts of the mixture of the oils A and silanes B, and 2) the 3 constituents A, B and C are left to interact at .. temperature ranging from 5 °C to 180 °C, this process being characterised by the following points :

i) the oils A have viscosities which range from 70 to 500 mPa · s at 25 °C,

ii) the oils A and silanes B are mixed in proportions such that the mole ratio of hydroxyl radicals in the oils/Q radicals in the silanes ranges from 0.1 to 0.95,

iii) the three reagents A, B and C are maintained in contact for the time required for removal of at most 45 % of the theoretical amount of the alcohol QH which must be formed from the OH radicals of the oils A and Q radicals of the silanes B.

2. Process according to Claim 1, in which the three reagents A, B and C are simply maintained in contact for at least 10 hours at a temperature ranging from 5 °C to 90 °C, without substantial removal of the alcohol QH.

3. Compositions which can be photopolymerised by ultraviolet radiation, containing, for 100 parts by weight of the compositions according to Claims 1 or 2 in which the symbol Z denotes a $CH_2{=}C\,(R')COO$ radical, 0.1 to 10 parts of a photosensitizer chosen from benzoin derivatives, xanthone derivatives or thioxanthone derivatives.

4. Use of the compositions according to Claim 3 in the non-stick treatment of solid materials.

**Patentansprüche**

1. Verfahren zur Herstellung von lagerbeständigen Organopolysiloxan-Zusammensetzungen mit Viskositäten von 60 mPa · s bis 20 000 mPa · s bei 25 °C, die funktionelle, an die Siliciumatome gebundene Reste tragen, ausgewählt unter den Resten Methacroyloxyalkyl, Acroyloxyalkyl und Mercaptoalkyl, wobei 1) in Kontakt gebracht werden :

A) α,ω-Dihydroxydiorganopolysiloxan-Öle, deren organische, an die Siliciumatome gebundene Reste ausgewählt sind unter den Resten Methyl, Ethyl, n-Propyl, Vinyl, Phenyl, Trifluorpropyl, wobei mindestens 70 % dieser Reste Methylreste und höchstens 3 % Vinylreste sind,

B) Silane der allgemeinen Formel $Z(G)SiR_a(Q)_{3-a}$, worin das Symbol Z den Rest $CH_2{=}C\,(R')\text{—}COO$ oder den Rest HS bedeutet ; wobei die Symbole R, die identisch oder verschieden sind, Methyl-, Ethyl-, n-Propyl-, Vinyl-, Phenylreste bedeuten ; das Symbol R' ein Wasserstoffatom oder einen Methylrest bedeutet ; die Symbole Q, die identisch oder verschieden sind, Methoxy-, Ethoxy-, n-Propoxy-, β-Methoxyethoxyreste bedeuten und wobei zwei Symbole Q zusammen einen Rest der Formel

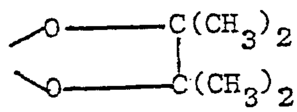

bedeuten ; das Symbol G einen geraden oder verzweigten Alkylenrest mit 1 bis 8 Kohlenstoffatomen bedeutet ; das Symbol a einen Wert von 0 bis 2 bedeutet,

C) Katalysatoren ausgewählt unter den Alkyltitanaten und -polytitanaten und den Diorganozinnsalzen aliphatischer Säuren, in einem Verhältnis von 0,05 bis 2 Teilen pro 100 Teile des Gemisches der Öle A und der Silane B, und 2) die drei Bestandteile A, B und C bei einer Temperatur von 5 °C bis 180 °C untereinander reagieren gelassen werden, wobei dieses Verfahren durch die folgenden Punkte gekennzeichnet ist :

i) Die Öle A haben Viskositäten von 70 bis 500 mPa · s bei 25 °C,

ii) die Öle A und die Silane B werden in solchen Mengenverhältnissen gemischt, daß das Mol-Verhältnis der Hydroxylreste der Öle/Reste Q der Silane sich von 0,1 bis 0,95 erstreckt,

iii) die drei Reaktanten A, B und C werden während einer solchen Zeit in Kontakt gehalten, die notwendig ist, um höchstens 45 % der theoretischen Menge des Alkohols QH zu entfernen, der sich aus den Resten OH der Öle A und den Resten Q der Silane B bilden soll.

2. Verfahren gemäß Anspruch 1, dadurch gekennzeichnet, daß die drei Reaktanten A, B und C einfach während mindestens 10 Stunden in Kontakt gehalten werden, bei einer Temperatur, die sich von 5 °C bis 90 °C erstreckt, ohne wesentliche Entfernung des Alkohols QH.

3. Zusammensetzungen, die durch Ultraviolettstrahlen photopolymerisierbar sind, umfassend pro

100 Gewichtsteile der Zusammensetzungen gemäß den Ansprüchen 1 oder 2, worin das Symbol Z den Rest $CH_2=C(R')COO$ bedeutet, 0,1 bis 10 Teile eines Photosensibilisators, ausgewählt unter den Derivaten des Benzoins, des Xanthons oder des Thioxanthons.

4. Verwendung der Zusammensetzungen gemäß Anspruch 3 zur Antihaftbehandlung von festen Materialien.